Europäisches Patentamt

(19) European Patent Office

Office européen des brevets

(11) EP 0 809 116 A1

(12) **DEMANDE DE BREVET EUROPEEN**

(43) Date de publication:
26.11.1997 Bulletin 1997/48

(51) Int Cl.⁶: **G01R 31/08**

(21) Numéro de dépôt: 97401123.1

(22) Date de dépôt: 21.05.1997

(84) Etats contractants désignés:
DE ES GB IT

(30) Priorité: 22.05.1996 FR 9606365

(71) Demandeur: FRANCE TELECOM
75015 Paris (FR)

(72) Inventeur: **Herry, Jacques**
22300 Lannion (FR)

(74) Mandataire: **Armengaud Ainé, Alain et al**
**Cabinet ARMENGAUD AINE**
3 Avenue Bugeaud
75116 Paris (FR)

(54) **Procédé et appareil pour la localisation et la détermination de défaut sur un câble**

(57) Procédé de détermination et de localisation de défaut sur un câble, se caractérise en ce qu'on procède sur le câble au repérage d'un fil "sain" et d'un fil "suspect" par une mesure et une analyse des tensions par rapport à la terre, puis on effectue une série de quatre mesures en deux points distincts du circuit, à savoir deux mesures en un point, une en configuration circuit ouvert et une en circuit fermé, puis deux autres mesures à l'autre point du circuit, une également en circuit ouvert, puis une en circuit fermé, ces quatre mesures étant alors mémorisées et permettent d'obtenir, après calcul dans un algorithme, la localisation du défaut sur le fil "suspect".

*FIG.1*

**Description**

La présente invention est relative à un procédé de mesure et de localisation de défauts sur des câbles métalliques, tels que des câbles téléphoniques multipaires, informatiques ou électriques. Ce procédé permet de localiser l'endroit du défaut même en cas de mélanges généralisés dans les fils, ainsi que pour des résistances de défauts de très forte valeur.

Les procédés connus de détermination et de localisation des défauts sur un câble sont basés sur une utilisation de ponts traditionnels à résistance ou de ponts automatiques de mesures.

Les ponts traditionnels sont de plus en plus abandonnés au profit des ponts automatiques de localisation, mais ces derniers sont d'une fiabilité incertaine s'il y a des tensions parasites sur le câble, et demeurent d'un usage assez complexe sur le terrain, car ils présentent la particularité de travailler avec des tensions importantes, de l'ordre de 150 V, ce qui peut entraîner des détériorations sur les installations reliées sur le câble, et un danger pour l'utilisateur.

De plus, en cas de défaut généralisé sur le câble, il est très difficile voire quasiment impossible de trouver un fil sain, sans tension parasite, dans le câble.

Par ailleurs, la mise en oeuvre de certains de ces procédés de mesure, nécessite un rapport d'isolement entre un fil sain et un fil à défaut souvent supérieur à 1000 et l'absence de tension parasite sur le fil afin de ne pas empêcher l'équilibrage du pont, d'autres n'exigent qu'un rapport d'isolement de 2, mais obligent la présence d'un utilisateur à chaque extrémité du câble, pour ouvrir ou fermer le circuit.

La présente invention vise à pallier ces inconvénients en proposant un procédé de mesure et de localisation de défaut indépendant des tensions parasites présentes sur les fils, du rapport d'isolement entre ces derniers. Ce procédé est basé sur une mesure de courant en circuit fermé et en circuit ouvert, et s'affranchit des techniques connues (variation de résistance (pont traditionnel), mesure de courant dans deux bras différents avec recours à des intégrateurs (pont automatique).

A cet effet, le procédé de détermination et de localisation de défaut sur un câble, se caractérise en ce qu'on procède sur le câble au repérage d'un fil "sain" et d'un fil "suspect" par une mesure et une analyse des tensions par rapport à la terre, puis on effectue une série de quatre mesures en deux points distincts du circuit, à savoir deux mesures en un point, une en configuration circuit ouvert et une en circuit fermé, puis deux autres mesures à l'autre point du circuit, une également en circuit ouvert, puis une en circuit fermé, ces quatre mesures sont alors mémorisées et permettent d'obtenir, après calcul dans un algorithme, la localisation du défaut sur le fil "suspect".

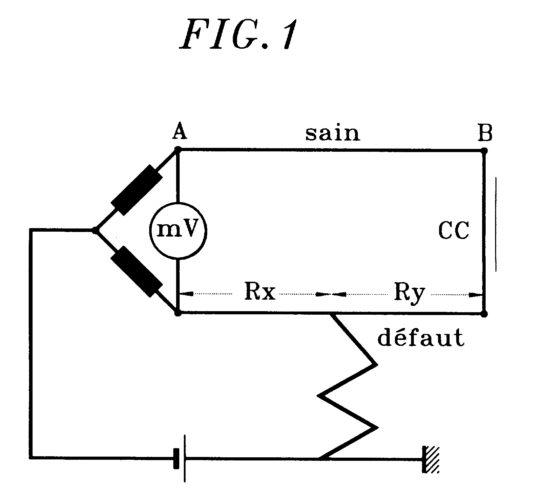

D'autres caractéristiques et avantages de la présente invention ressortiront de la description faite ci-après, en référence aux dessins annexés qui en illustrent un exemple de réalisation dépourvu de tout caractère limitatif. Sur la figure 1 :

- la figure 1 illustre le schéma de principe du circuit électrique établi autour d'un fil "sain" et d'un fil "suspect" permettant d'obtenir la localisation du défaut.

Selon un mode préféré de mise en oeuvre du procédé objet de l'invention, celui-ci comporte tout d'abord une étape de détermination de la recherche d'une paire de fils sur le câble ou la portion de câble à tester ; cette paire de fils étant constituée d'un fil "sain" et d'un fil "à défaut". A l'aide d'une mesure de tension, réalisée par un multimètre approprié, on détecte entre l'un des fils de cette paire et la terre, la nature (niveau d'amplitude) et la forme de cette tension (présence éventuelle de parasites).

En cas de tension faible, éventuellement parasitée, on filtre cette tension par des moyens connus (transformateur d'isolement, filtre passe bas..) et on l'utilise pour procéder à la mesure de localisation de défaut. Si toutefois cette tension avait un niveau trop faible, elle est substituée par une tension interne stabilisée, et à demeure sur le dispositif chargé de la mise du procédé objet de l'invention.

Dans le cas contraire, en cas de tension forte éventuellement parasitée, on ne peut pas utiliser cette tension directement pour effectuer la détermination de la localisation du défaut, étant donné les risques de détérioration pour les matériels en ligne et d'électrocution pour l'utilisateur, et il convient donc de mettre cette tension à la terre, et on utilise donc la tension interne du dispositif, comme précédemment décrit.

L'autre fil constituant la paire est testé de la même manière, et la valeur de tension est comparée avec celles de la précédente mesure sur l'autre fil.

Si la valeur de la tension est normalisée par rapport aux critères d'utilisation du câble, le fil de la paire auscultée est considéré comme fil "sain" et il peut servir de référence pour tous les autres tests qui seront effectués sur ce même câble. La présence d'une tension anormalement faible, forte, parasitée par rapport à ces mêmes critères sur un fil, révèle que ce fil est en défaut par rapport à son environnement, il peut être mélangé, en défaut d'isolement par rapport à un autre fil du câble ou par rapport à la terre.

Ces deux fils étant repérés, ils sont connectés aux bornes respectives du dispositif pour la mise en oeuvre du procédé.

Ce dispositif, outre ces deux bornes, qui peuvent être interchangeables, comporte un jeu de deux résistances parfaitement calibrées qui sont placées entre les deux bornes. Entre ces deux résistances et la terre, on connecte une alimentation stabilisée de quelques dizaines de volt qui est compatible avec le circuit, pour ne pas détruire tout l'appareillage relié au câble. En parallèle sur ces bornes, on dispose un galvanomètre, éventuellement pourvu d'un dispositif de filtrage des tensions parasites

Le circuit formé par le dispositif de localisation du défaut, le fil "sain", le fil "suspect ou à défaut potentiel" est bouclé par un circuit temporisateur CC, équipé d'un relais d'ouverture et de fermeture du circuit, à alimentation autonome, et qui peut être commandé depuis ledit dispositif par l'envoi d'une fréquence.

Le dispositif comprend également une pluralité de circuits de mémorisation et d'affichage destinés à la sauvegarde des différentes mesures réalisées lors des diverses étapes, en vue de la localisation du défaut sur le fil présumé "suspect".

Après avoir repéré une paire de fils, dont l'un est "sain" et l'autre est "suspect", on procède alors à une mesure de courant ou de tension en circuit ouvert à l'une des extrémités du circuit (Aou) ; cette donnée est mémorisée et éventuellement affichée sur le dispositif.

Puis, on effectue ce même type de traitement sur le circuit fermé à la même extrémité, ce qui implique l'envoi, par le dispositif, au temporisateur de la fréquence appropriée pour fermer et réouvrir le circuit lorsque la mesure de courant ou de tension a été transmise aux circuits de mémorisation du dispositif (Acc).

L'étape suivante consiste à exécuter la première étape, mais en déplaçant le point de mesure à l'autre extrémité du circuit ; bien entendu, le point de mesure est stocké en vue d'un calcul ultérieur et peut être affiché si besoin (Bou).

La dernière phase en vue de la localisation du défaut, consiste à réexécuter l'étape précédente : point de mesure à l'autre extrémité du circuit, mais en circuit fermé (Bcc).

Les quatre points de détermination suivants :

- mesure à un point A du circuit, l'autre point du circuit B étant ouvert (Aou) ;
- mesure à un point A du circuit, l'autre point du circuit B étant fermé (Acc) ;
- mesure à un point B du circuit, l'autre point du circuit A étant ouvert (Bou) ;
- mesure à un point B du circuit, l'autre point du circuit A étant fermé (Bcc) ;

génèrent autant de valeurs qui permettent, si la longueur totale du fil suspect est connue, de déterminer et de positionner par rapport à l'une des origines A ou B, l'endroit du défaut selon la formule suivante :

$$\text{Distance } (x) = \frac{\text{Longueur du cable}}{1 + \dfrac{\text{Acc} \times \text{Bou}}{\text{Bxx} \times \text{Aou}}}$$

Le procédé précédemment décrit permet aussi bien de détecter des défauts d'isolement sur des lignes pour des valeurs comprises notamment entre 0 Ω et 100 MΩ.

Ce procédé est particulièrement adapté pour effectuer la localisation de défauts sur des câbles pupinisés, ou la résistance donnée des pupins est toute relative, car dans ce cas, il n'est pas nécessaire de faire de corrections pupins pour déterminer avec précision l'endroit du défaut. Il assure également un suivi préventif des installations sous surveillance avant que les défauts apparaissent et occasionnent des coupures de lignes.

Il demeure bien entendu que la présente invention n'est pas limitée aux exemples de réalisation décrits et représentés ci-dessus, mais qu'elle en englobe toutes les variantes.

**Revendications**

1. Procédé de détermination et de localisation de défaut sur un câble, se caractérise en ce qu'on procède sur le câble au repérage d'un fil "sain" et d'un fil "suspect" par une mesure et une analyse des tensions par rapport à la terre, puis on effectue une série de quatre mesures en deux points distincts du circuit, à savoir deux mesures (Aou, Acc) en un point A, une en configuration circuit ouvert et une en circuit fermé, puis deux autres mesures (Bou, Bcc) à l'autre point du circuit B, une également en circuit ouvert, puis une en circuit fermé, ces quatre mesures étant alors mémorisées et permettent d'obtenir, après calcul dans un algorithme, la localisation du défaut sur le fil "suspect".

2. Procédé de détermination et de localisation de défaut sur un câble selon la revendication 1, caractérisé en ce qu'un effectue le passage d'une configuration, circuit ouvert à circuit fermé, et réciproquement, à l'aide d'une télécommande positionnée à l'une des extrémités (A,B) du circuit, commandée en fréquence.

3. Appareil pour la mise en oeuvre du procédé selon l'une des revendications 1 ou 2, caractérisé en ce qu'il comporte :

   - au moins deux bornes, qui peuvent être interchangeables, pour le branchement des fils,
   - un jeu de deux résistances parfaitement calibrées qui sont placées entre lesdites bornes,
   - une alimentation stabilisée de quelques dizaines de volt qui est reliée entre le point milieu des résistances et la terre ou la source du défaut suivant le cas,
   - un galvanomètre, éventuellement pourvu d'un dispositif de filtrage des tensions parasites,
   - une commande en fréquence d'un temporisateur,
   - des circuits de mémorisation et d'affichage des points de mesure.

*FIG. 1*

A  B  sain  CC  mV  Rx  Ry  défaut

Office européen    RAPPORT DE RECHERCHE EUROPEENNE

des brevets

Numero de la demande

EP 97 40 1123

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 4 424 479 A (BROWN) <br> * revendication 1; figure 1 * <br> --- | 1 | G01R31/08 |
| A | DE 37 27 224 A (SIEMENS) <br> * figure 1 * <br> --- | 1 | |
| A | RADIO FERNSEHEN ELEKTRONIK, <br> vol. 43, no. 11, Novembre 1994, BERLIN, DE, <br> page 44 XP000479734 "Fehlerortung in Kabelnetzen" <br> --- | 1 | |
| A | PROC. OF THE 1994 IEEE POWER ENGENEERING SOCIETY TRANSMISSION AND DISTRIBUTION CONFERENCE, <br> 10 - 15 Avril 1994, CHICAGO, US, <br> pages 376-382, XP000470557 <br> BASCOM ET AL.: "computerized underground cable fault location expertise" <br> * figures 1-9 * <br> ----- | 1 | |
| | | | DOMAINES TECHNIQUES RECHERCHES (Int.Cl.6) |
| | | | G01R |

Le présent rapport a été établi pour toutes les revendications

| Lieu de la recherche | Date d'achèvement de la recherche | Examinateur |
|---|---|---|
| LA HAYE | 3 Juillet 1997 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................................................
& : membre de la même famille, document correspondant

EPO FORM 1503 03.82 (P04C02)